# EUROPEAN PATENT SPECIFICATION

(11) **EP 2 906 024 B1**
(45) Date of publication and mention of the grant of the patent: **26.07.2017**
(21) Application number: 15150673.0
(22) Date of filing: 09.01.2015
(51) Int. Cl.: H05K 1/02, H04B 1/3822, H05K 3/28, H05K 5/06, G06K 19/077, H01Q 1/00, H01Q 1/32, H01Q 1/40, H05K 1/16, H05K 1/18

(54) **Communication device and production method therefor**
Kommunikationsvorrichtung und Herstellungsverfahren dafür
Dispositif de communication et procédé de production associé

(30) Priority: 15.01.2014 JP 2014004757; 24.10.2014 JP 2014216809
(43) Date of publication of application: 12.08.2015
(73) Proprietor: Hitachi, Ltd., Tokyo 100-8280 (JP)
(72) Inventor: Inoue, Takeshi, Chiyoda-ku, Tokyo 100-8280 (JP); Okamoto, Takeshi, Chiyoda-ku, Tokyo 100-8280 (JP); Horino, Masaya, Chiyoda-ku, Tokyo 100-8280 (JP)
(74) Representative: Moore, Graeme Patrick

(56) References cited:
- WO-A1-2012/128127
- DE-A1- 4 319 878
- FR-A1- 2 980 932
- US-A- 5 321 240
- US-A1- 2008 023 793
- US-A1- 2013 321 238

## Description

### BACKGROUND OF THE INVENTION

### Field of the Invention

The present invention relates to a communication device and a production method therefor.

### Description of the Related Art

US 5,321,240 discloses a non-contact IC card.

US 5,448,110 discloses an enclosed transceiver.

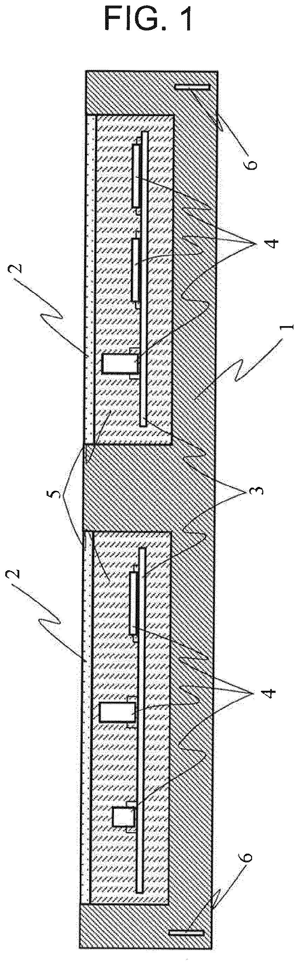

FIG. 1 is a cross-sectional diagram showing an example of a conventional ground communication device or vehicle communication device.

In FIG. 1, a substrate 3 having multiple electronic components 4 mounted thereon is contained in the interior of a housing 1 having an antenna 6, which is used for the sending and receiving of positional information, buried therein. In order to get a vibration isolation effect against the vibration at the time of running of a mobile body, a moisture exclusion effect against the outdoor environment and a heat radiation effect against the heat generation of the electronic components 4 themselves, the substrate 3 containing the electronic components 4 has a structure in which the housing 1 is filled with a sealing member 5 up to the top edge and is sealed with a ceiling plate 2.

Specification of EP Patent No. 1697195 describes that the periphery of a circuit substrate is filled with a silicon resin.

Further, the description of the abstract of Japanese Patent Laid-Open No. 9-142301 is as follows.
"A sending/receiving coil 1 sends or receives information waves S21, S22 that are sent and received between a vehicle and the ground. A data conversion circuit 2 converts input sending data S1 into the information wave S21 that is different in frequency, supplies the information wave S21 to the sending/receiving coil 1, converts the information wave S22 received by the sending/receiving coil 1, into receiving data S3 that is different in frequency, and outputs the receiving data S3. A case 3, which is composed of an insulating material, contains the sending/receiving coil 1 and the data conversion circuit 2".

Further, Japanese Patent Laid-Open No. 9-142301 describes that, in the interior of the case 3, the sending/receiving coil 1 and the data conversion circuit 2 are molded by insulating resins 31, 32.

In recent years, the antenna 6 to be used for the sending and receiving of the positional information described above is sometimes buried in the substrate 3, to be integrated, for achieving the downsizing and cost reduction of the device. However, when the antenna 6 is buried in the substrate 3 in this way, there is a possibility that radio waves to be sent and received through the antenna 6 are damped by the sealing member 5 with which the housing 1 is filled up to the top edge and a predetermined radio wave performance is not exerted.

Hence, an object of the present invention is to provide a sealing structure that exerts a sufficient vibration isolation effect, moisture exclusion effect and heat radiation effect for the substrate 3 having the electronic components 4 mounted thereon, while suppressing the damping of radio waves to be sent and received through the antenna 6, by adjusting the arrangement of the antenna 6 buried in the substrate 3 and the electronic components 4, and the thickness of the sealing member 5, in a communication device in which the antenna 6 is buried in the substrate 3.

### SUMMARY OF THE INVENTION

For solving the above problem, the configurations as defined in the claims are adopted.

The present application includes a plurality of means for solving the above problem. The present invention provides a communication device as set forth in claim 1. Further, the present invention provides a communication device production method as set forth in claim 9.

According to the present invention, it is possible to secure a vibration isolation effect, and therewith to actualize a communication device that has a good radio wave performance. Further, it is possible to perform the filling with the raw material before solidification for forming the sealing member, separately between the first height for the low-level electronic component and the second height for the high-level electronic component, and therefore, it is possible to efficiently produce the above communication device.

Problems, configurations and effects other than the above will be revealed in the following description of embodiments.

### BRIEF DESCRIPTION OF THE DRAWINGS

FIG. 1 is a cross-sectional diagram showing an example of a conventional ground communication device or vehicle communication device;
FIG. 2 is a cross-sectional diagram showing a first embodiment in which the present invention is applied to a vehicle communication device;
FIG. 3 is a diagram showing the optimum dimension of the thickness of a low-level sealing member in the first embodiment;
FIG. 4 is a diagram showing the optimum dimensions of the thickness of a high-level sealing member and the distance between an antenna buried in a substrate and the high-level electronic component, in the first embodiment;
FIG. 5 is a diagram showing a second embodiment in which the present invention is applied to a vehicle communication device, and a production method;
FIG. 6 is a diagram showing a production method according to the first embodiment;
FIG. 7 is a diagram showing a third embodiment in which the present invention is applied to a vehicle communication device; and
FIG. 8 is a diagram showing a fourth embodiment in which the present invention is applied to a ground communication device.

### DETAILED DESCRIPTION OF THE PREFERRED EMBODIMENTS

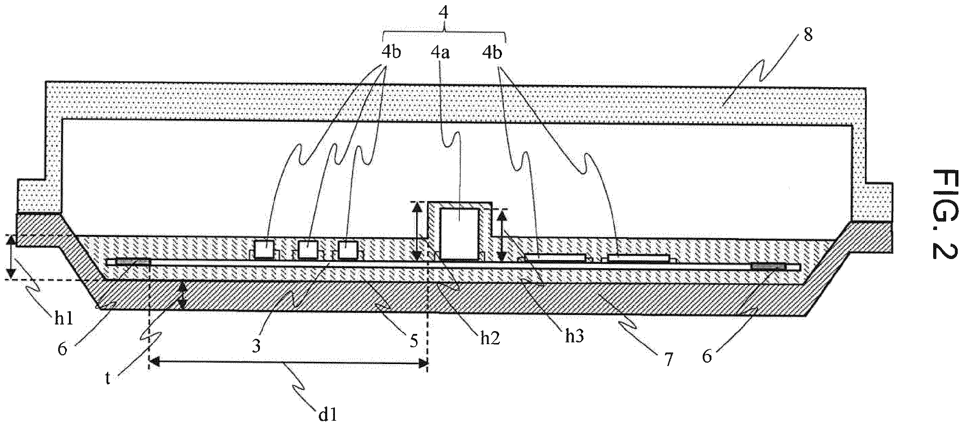

In the following, embodiments of a communication device to which the present invention is applied will be described using FIG. 2 to FIG. 8. Here, in the following description, the same reference characters are assigned to the same functional parts, and repetitive descriptions are omitted.

FIG. 2 is a cross-sectional diagram of a configuration showing the mode of Embodiment 1 that is applied to a vehicle communication device of the communication device according to the present invention. As shown in FIG. 2, in the vehicle communication device, a housing is constituted by a bottom plate 7 molded in a bowl shape and having a predetermined depth, and a ceiling plate 8 molded in a bowl shape.

The vehicle communication device, in which an underfloor portion of a mobile body and the ceiling plate 8 are joined by bolt fastening or the like, sends a radio wave containing positional information, toward a ground communication device installed on the ground side, that is, toward the downward direction in FIG. 2. Therefore, it is preferable to use, as the bottom plate 7, a glass-fiber reinforced plastic that has a good strength, heat resistance and water resistance, and that has a good radio wave transmission property, for example.

A substrate 3 having multiple electronic components 4 mounted thereon is attached to the bottom plate 7, and an antenna 6 is buried in the outer circumference portion of the substrate 3, to be integrated.

As shown in FIG. 2, the vehicle communication device has a configuration in which the substrate 3 having the multiple electronic components 4 thereon is covered with a sealing member 5. As the sealing member 5, for example, a material having a good vibration isolation property, airtight property and heat radiation property, such as a polyurethane resin is used. However, generally, such a material has a low radio wave transmission property, and the vibration isolation property, airtight property and heat radiation property are in a trade-off relation with the radio wave transmission property.

Hence, the embodiment focuses on the presence of high-level electronic components 4a, in which the height in the direction perpendicular to the plane of the substrate 3 is large, and low-level electronic components 4b, in which the height is small, of the electronic components 4 mounted on the substrate 3. Then, the arrangement of the high-level electronic component 4a and the low-level electronic component 4b on the substrate 3 is optimized relative to the antenna 6, and the thickness of the sealing member 5 is set to a minimally necessary thickness from the side surface and top surface, for each of the high-level electronic component 4a and the low-level electronic component 4b, allowing for a desired vibration isolation property, airtight property and heat radiation property.

Specifically, in the embodiment, the antenna 6 is arranged along the outer circumference of the substrate 3, the high-level electronic component 4a is laid out at the vicinity of the central portion of the substrate 3, which is a position away from the antenna 6 by a predetermined distance, and the low-level electronic component 4b is laid out at the outer circumference thereof.

For the low-level electronic component 4b, the thickness of the sealing member 5 is set to a low-level sealing member thickness h1, such that the sealing member 5 covers the top surfaces of all the low-level electronic components 4b at a predetermined thickness.

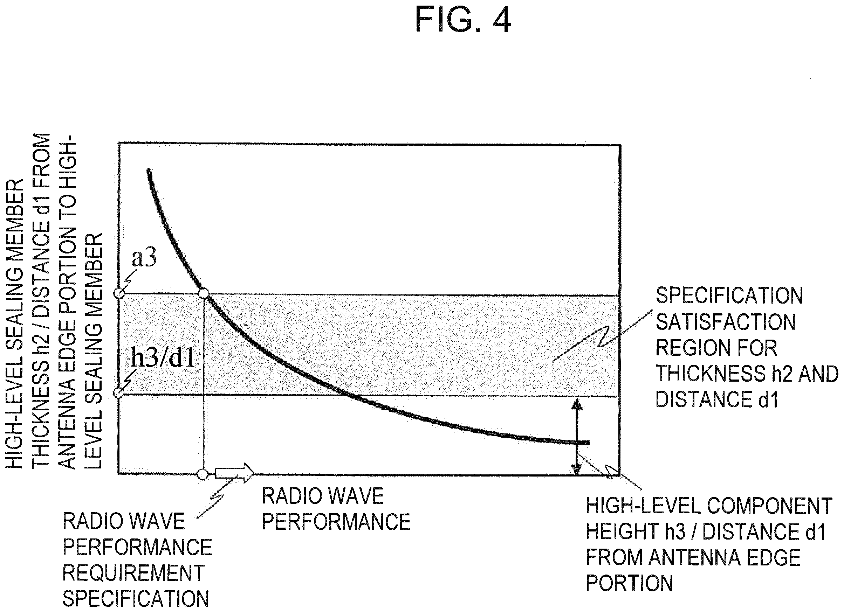

On the other hand, for the high-level electronic component 4a arranged at the central portion, which is a position away from the antenna 6 by a predetermined distance, a high-level sealing member thickness h2 is set such that the sealing member 5 covers the side surface and top surface at a certain thickness. In the embodiment, the high-level electronic component 4a is arranged at the vicinity of the central portion of the substrate 3. As described in the following explanation with FIG. 4, in the present invention, the predetermined distance between the antenna 6 and the high-level electronic component 4a is important. Therefore, if the predetermined distance is provided, the effect of the present invention is exerted, even when the high-level electronic component 4a is arranged at a position deviated from the central portion of the substrate 3, or even when the antenna 6 is arranged at an arbitrary position on the substrate. However, when the high-level electronic component 4a is arranged at the vicinity of the central portion of the substrate 3 and the antenna 6 is circularly arranged at the outer circumference portion of the substrate, the symmetry of the product is secured and the stability in the installation of the communication device is improved.

Generally, centering on the axis line direction of the antenna 6, as an object to obstruct the radio wave transmission becomes closer in the radial direction and becomes longer in the circumferential direction, the radio wave damping degree increases.

In response, in the vehicle communication device according to the embodiment, the low-level electronic components 4b are arranged at the vicinity of the peripheral portion of the antenna 6 buried in the substrate 3, and the high-level electronic components 4a are arranged at the positions away from the antenna 6.

Then, for these high-level electronic components 4a, the side surfaces and top surfaces are covered with the sealing member 5 having a minimally necessary thickness.

By adopting such a structure, it is possible to secure a good vibration isolation effect, moisture exclusion effect and heat radiation effect, to reduce the circumferentially-directional length of the sealing member 5 that is close in the radial direction as viewed from the axis line direction of the antenna 6, to a minimally necessary length, and to secure a good radio wave performance and transmit a predetermined radio wave from the antenna 6.

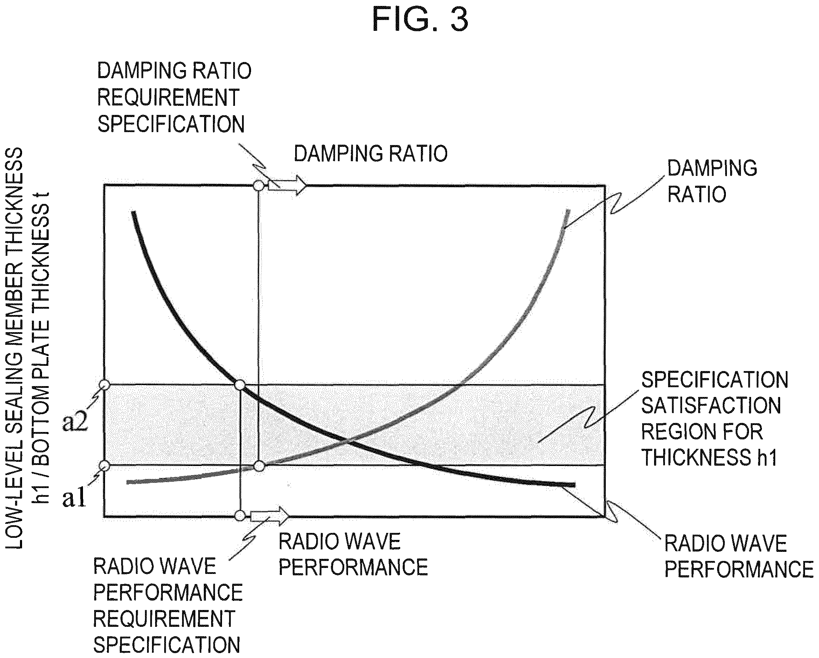

FIG. 3 is a diagram showing the optimum dimension of the low-level sealing member thickness h1 that is necessary for covering the low-level electronic component 4b and substrate 3 shown in FIG. 2. That is, this is a diagram showing the relation among the value resulting from dividing the low-level sealing member thickness h1 by the plate thickness t of the bottom plate 7 as the reference, the radio wave performance to be sent from the antenna 6, and the damping ratio of the vertical vibration of the sealing member 5 covering the electronic components 4 and substrate 3 and the bottom plate 7.

By increasing h1/t, which is indicated on the ordinate, the damping ratio to be obtained rises upward to the right, but on the other hand, the radio wave performance falls downward to the right. Therefore, it is preferable that the low-level sealing member thickness h1 be set in a specification satisfaction region in which both of the requirement specification of the damping ratio and the requirement specification of the radio wave performance are satisfied.

Therefore, h1/t may be value that is greater than or equal to the lowest value a1 for satisfying the requirement specification of the damping ratio, and that is less than or equal to a2 for satisfying the requirement specification of the radio wave performance, and in this example, a1 = 0.5 and a2 = 2.0 may be adopted. The vehicle communication device configured in this way can secure, as the radio wave performance to be obtained, a vibration damping ratio of 50% or less, that is, 50% or more of the maximum performance when there is no sealing member.

FIG. 4 is a diagram showing the optimum dimension of the thickness h2 from the top surface portion of the substrate 3 to the top edge portion of the high-level sealing member that is necessary for covering the high-level electronic component 4a shown in FIG. 2, and the optimum dimension of the distance d1 from the edge portion of the antenna 6 to the edge portion of the high-level sealing member. That is, this is a diagram showing the relation between the value resulting from dividing the high-level sealing member thickness h2 by the distance d1 from the antenna 6, and the radio wave performance to be sent from the antenna 6.

By decreasing the high-level electronic component thickness h2 and increasing the distance d1 from the antenna 6, the radio wave performance increases. Therefore, it is preferable that h2/d1 be a value for satisfying a desired radio wave performance specification, that is, be less than or equal to a3, and in this example, a3 = 0.2 may be adopted.

The vehicle communication device configured in this way can secure, as the radio wave performance, 50% or more of the maximum performance. Here, since the thickness h3 of the high-level electronic component 4a is previously determined, it is preferable to set the distance d1 from the antenna edge portion such that a predetermined vibration damping ratio can be obtained and a predetermined sealing member thickness can be secured relative to the top surface of the high-level electronic component 4a, on the premise that the high-level sealing member thickness h2 becomes thicker than the high-level electronic component thickness h3.

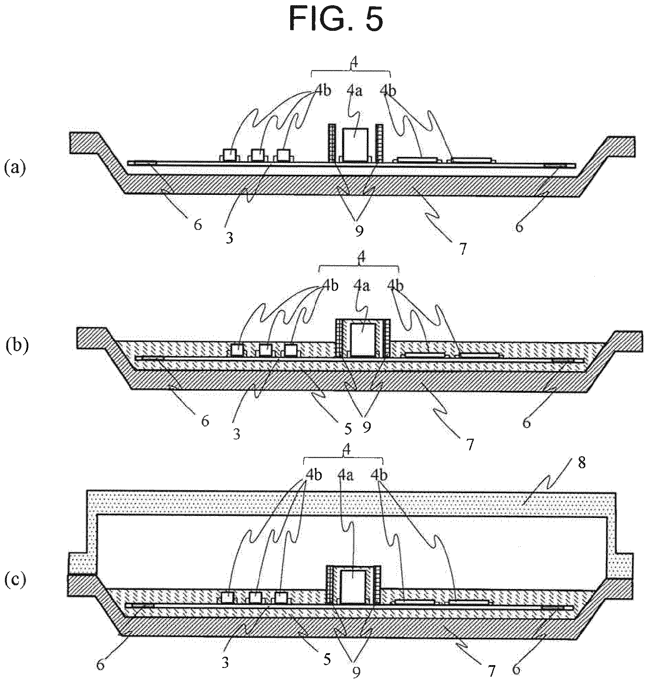

FIG. 5 is a diagram showing a second embodiment of a vehicle communication device of the communication device according to the present invention, and a diagram showing an example of a production method according to the present invention. FIG. 5(a) is a cross-sectional diagram before the filling with the sealing member 5, FIG. 5(b) is a cross-sectional diagram after the filling with the sealing member 5, and FIG. 5(c) is a cross-sectional diagram when the second embodiment is completed. FIG. 5 is different from FIG. 2 in that a shielding member 9 is provided at the peripheral portion of the high-level electronic component 4a, and is the same as FIG. 2 in the others.

As shown in FIG. 5(a), on the substrate 3 having the electronic components 4 mounted thereon, the shielding member 9 is provided so as to surround the peripheral portion of the high-level electronic component 4a. Preferably, the shielding member 9 should be made of a material having a good radio wave transmission property such as a glass-fiber reinforced plastic, for example. Here, the substrate 3 provided with the electronic components 4 and the shielding member 9 is fixed to the bottom plate 7 by a fixing pin or the like.

As shown in FIG. 5(b), the high-level portion and low-level portion separated by the shielding member 9 are each filled with the sealing member 5. As shown in FIG. 5(c), the ceiling plate 8 is attached to the bottom plate 7, to which the substrate 3 provided with the electronic components 4 and the shielding member 9, and the sealing member 5 are attached.

For example, in the case of using, as the sealing member 5, a material resulting from mixing a polyurethane resin having a high fluidity with a curing agent, the thickness is equalized before the solidification of the sealing member 5. Therefore, by providing the shielding member 9, it is possible to solidify the sealing member 5 such that the low-level portion and the high-level portion are different in thickness.

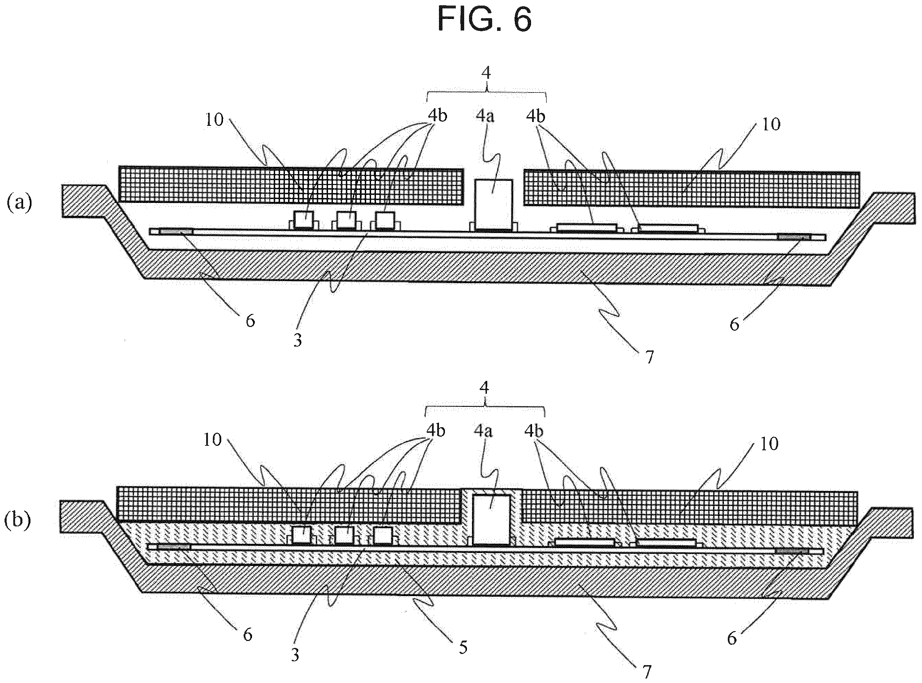

FIG. 6 is a diagram showing a production method that results in the first embodiment of the vehicle communication device of the communication device according to the present invention. FIG. 6(a) is a cross-sectional diagram before the filling with the sealing member 5, and FIG. 6(b) is a cross-sectional diagram after the filling with the sealing member 5.

As shown in FIG. 6(a), a mold member 10 in which a release agent is applied on the surface is provided at an upper portion of the bottom plate 7 on which the substrate 3 having the electronic components 4 mounted thereon is provided. The mold member 10, on which a hole is provided at a spot corresponding to the high-level electronic component 4a, is configured such that the thickness from the substrate when it is attached to the upper portion of the bottom plate 7 is thicker than the thickness of the high-level electronic component 4a from the substrate. In a state in which the mold member 10 is attached to the upper portion of the bottom plate 7, the sealing member 5 is poured into the hole provided on the mold member 10, and the electronic components 4 and the substrate 3 are sealed.

The sealing member 5 is injected up to a position where the high-level electronic component 4a is covered. After the sealing member 5 is solidified, the mold member 10 is removed, and the ceiling plate 8 is attached to the upper portion of the bottom plate 7. Thereby, the first embodiment shown in FIG. 2 is produced. For example, in the case of using, as the sealing member 5, a material resulting from mixing a urethane resin having a high fluidity with a curing agent, by providing the mold member 10, it is possible to solidify the sealing member 5 such that the low-level portion and the high-level portion are different in thickness, without using the shielding member.

Further, it is also possible that, without applying the release agent on the surface, the mold member 10 shown in FIG. 6(a) is attached to the upper portion of the bottom plate 7 on which the substrate 3 having the electronic components 4 mounted thereon is provided, the sealing member 5 is poured into the hole provided on the mold member 10, and thereafter, in a state in which the mold member 10 is left, the ceiling plate 8 is attached to the upper portion of the bottom plate 7. Since the mold member 10 is left, it is possible to attach the ceiling plate 8 to the upper portion of the bottom plate 7, without requiring the time for solidifying the sealing member 5 in the production stage. On this occasion, preferably, the mold member 10 should be made of a styrene foam having a good radio wave transmission property, for example.

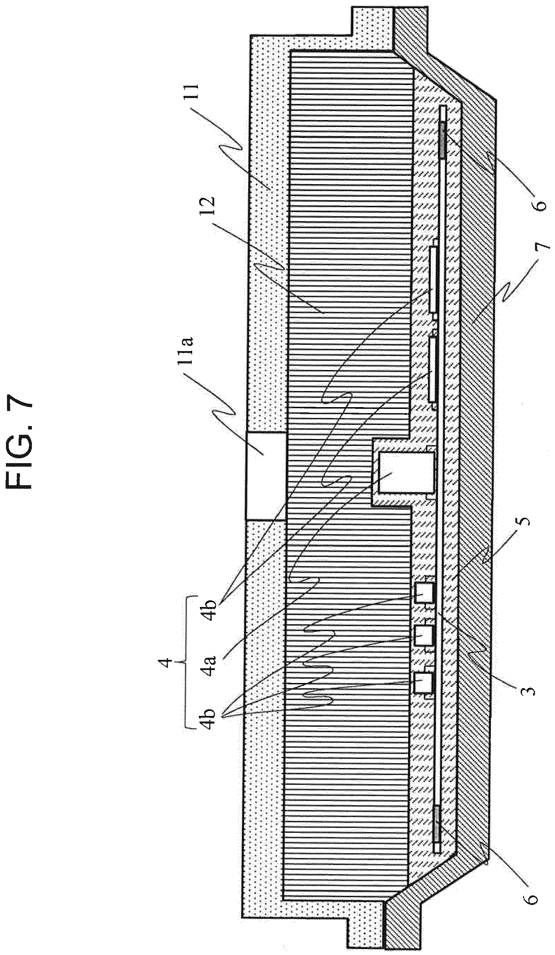

FIG. 7 is a cross-sectional diagram of the configuration showing a third embodiment of a vehicle communication device of the communication device according to the present invention. FIG. 7 is different from FIG. 2 in that a hole 11 a is provided at the central portion of the ceiling plate 11 and in that a second sealing member 12 is provided between the ceiling plate 11 and the sealing member 5, and is the same as FIG. 2 in the others. As shown in FIG. 7, the ceiling plate 11 in which the hole 11 a is provided at the central portion is attached to the upper portion of the bottom plate 7 that is provided with the electronic components 4 and substrate 3 covered with the sealing member 5. The hole 11 a provided on the ceiling plate 11 results in such a configuration that the second sealing member 12 having a high radio wave transmission property is poured and the space provided between the ceiling plate 11 and the sealing member 5 is filled with the sealing member 12. As the second sealing member 12, for example, a urethane foam or the like that is lightweight and that has some degree of vibration isolation effect, moisture exclusion effect and heat radiation effect may be used.

By the filling with the sealing member 12, the bottom plate 7 and the ceiling plate 11 are mechanically linked. Therefore, it is possible to suppress the vertical vibration of the sealing member 5 covering the electronic components 4 and substrate 3 and the bottom plate 7, and it is possible to get a predetermined damping effect even when the thickness of the low-level portion of the sealing member 5 is decreased. Further, since the high-level electronic component 4a is covered with the sealing member 5, for example, in the case of using a urethane foam as the second sealing member, it is possible to reduce the bending moment load and shearing load to the high-level electronic component 4a that are generated at the time of foaming and at the time of curing shrinkage, and to prevent the breakage of the joint portion between the high-level electronic component 4a and the substrate 3.

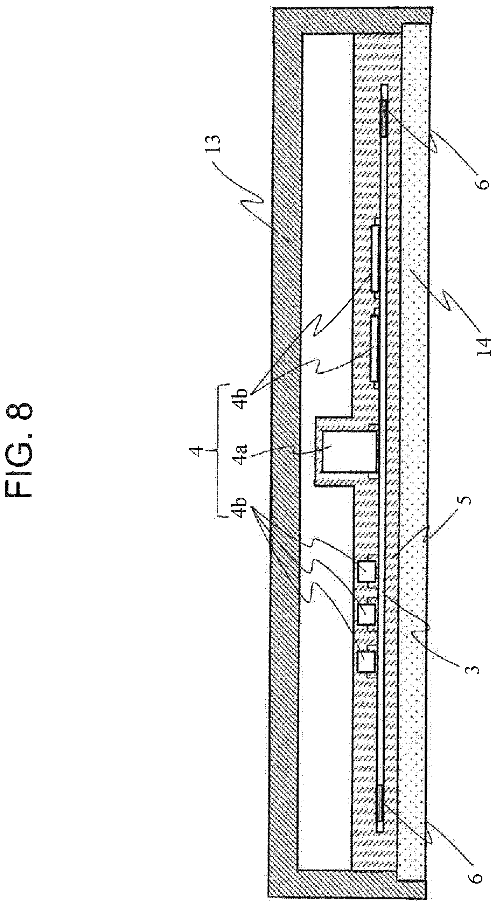

FIG. 8 is a cross-sectional diagram of the configuration showing a fourth embodiment of a ground communication device of the communication device according to the present invention. As shown in FIG. 8, in the ground communication device, a housing is constituted by a bottom plate 14 configured by a flat plate, and a ceiling plate 13 molded in a bowl shape. For example, the ground communication device is installed on a road surface, and is fixed to the bottom plate 14 that is a base provided just under the road surface. Further, in the case where the running course of a mobile body is unvarying and a supporting member for the running course is installed on the running course, it is only necessary to join the supporting member and the bottom plate 14, for example, by bolt fastening. By the joining to the supporting member, it is possible to reduce the cost of separately making a base for fixing the bottom plate 14. In the case where the ground communication device is installed in the outdoor environment in this way and a radio wave containing positional information is sent toward the upward direction in FIG. 8, it is preferable to use, as the ceiling plate 14, a glass-fiber reinforced plastic that has a good strength, heat resistance and water resistance, and that has a good radio wave transmission property, for example.

Here, the substrate 3 having the multiple electronic components 4 mounted thereon is attached to the bottom plate 14, and the antenna 6 is buried in the outer circumference portion of the substrate 3.

As shown in FIG. 8, the ground communication device has a configuration in which the substrate 3 having the multiple electronic components 4 mounted thereon is covered with the sealing member 5. Preferably, the sealing member 5 should be made of a material having a good vibration isolation property, airtight property and heat radiation property, such as a polyurethane resin, for example. The substrate 3 having the electronic components 4 mounted thereon is covered with the sealing member 5 having a thickness at which the low-level electronic component 4b is covered. The high-level electronic component 4a of the electronic components 4 is mounted at a position away from the antenna 6 buried in the substrate 3, and only the peripheral portion is covered with the sealing member 5 having an increased thickness.

In the ground communication device configured in this way, the sealing member 5 is not thick at the peripheral portion of the antenna 6 buried in the substrate 3, and it is possible to transmit a predetermined radio wave from the antenna 6, and to get a good vibration isolation effect, moisture exclusion effect and heat radiation effect for the substrate 3 and the electronic components 4.

Here, the present invention is not limited to the above embodiments, and includes various modifications. For example, the above embodiments have been described in detail for explaining the present invention clearly, and the present invention is not necessarily limited to embodiments including all the described configurations. Further, a part of a configuration in a certain embodiment can be replaced with a configuration in another embodiment, and to a configuration in a certain embodiment, a configuration in another embodiment can be added. Further, for a part of a configuration in each embodiment, the addition of another configuration, the deletion and the replacement can be performed.

## Claims

1. A communication device comprising:
multiple electronic components (4a, 4b) of different thickness;
a circuit substrate (3) provided with the multiple electronic components;
a bottom plate (7) that fixes the circuit substrate;
an antenna (6) provided in the circuit substrate; and
a sealing member (5) that covers the circuit substrate (3),
wherein the electronic components include a first electronic component (4b), and a second electronic component (4a) that has a thickness greater than the first electronic component in a direction perpendicular to the circuit substrate, and **characterized in that** the first electronic component (4b) is arranged at a vicinity of the antenna, and is covered with the sealing member (5) to a first height, and
the second electronic component (4a) is arranged at a position away from the antenna (6) by a predetermined distance to be further away from the antenna (6) than the first electronic component (4b) is from the antenna, and the second electronic component (4a) is covered with the sealing member to a second height, where the first height is lower than the second height.

2. The communication device according to claim 1,
wherein the first height is determined based on a thickness of the bottom plate (7), a damping ratio of vibration of the sealing member (5) and the bottom plate (7), and a radio wave performance to be sent from the antenna (6), and
the second height is determined based on the distance between the antenna (6) and the second electronic component (4a), and the radio wave performance.

3. The communication device according to claim 1,
wherein the second electronic component (4a) is arranged at a vicinity of a central portion of the circuit substrate (3).

4. The communication device according to claim 1,
wherein a shielding member (9) is provided between the sealing member (5) having the first height and the sealing member having the second height.

5. The communication device according to claim 4,
wherein the shielding member (9) is made of a radio wave transmitting material.

6. The communication device according to claim 1,
wherein an interval between the sealing member and a ceiling plate (8) for the electronic components (4a, 4b) is filled with a second sealing member (12) formed of a radio wave transmitting material.

7. The communication device according to claim 5,
wherein the second sealing member (12) is made of a urethane foam.

8. The communication device according to any of claim 1 to claim 7,
wherein the bottom plate (7) is made of a glass-fiber reinforced plastic, and
the sealing member (5) is made of a polyurethane resin.

9. A production method for the communication device according to claim 1, comprising:
a first step of fixing the circuit substrate (3) to the bottom plate (7);
a second step of forming a convex space having the second height, at a periphery of the second electronic component(4a);
a third step of performing a filling with a raw material before solidification, to the first height, for the first electronic component (4b), the raw material being a material for forming the sealing member (5);
a fourth step of filling the convex space with the raw material before solidification, the raw material being a material for forming the sealing member (5); and
a fifth step of solidifying the raw material after the filling in the third step and the fourth step.

10. The production method for the communication device according to claim 9,
wherein, in the second step, a shielding member (9) having the second height is fixed at the periphery of the second electronic component (4a), and thereby the convex space is formed.

11. The production method for the communication device according to claim 9,
wherein, in the second step, a mold member (10) is provided at the first height from the circuit substrate (3), the mold member (10) including a hole at a position corresponding to a peripheral portion of the second electronic component (4a) and having a thickness corresponding to a difference between the second height and the first height.

## Patentansprüche

1. Kommunikationsvorrichtung, umfassend:
mehrere elektronische Bauteile (4a, 4b) verschiedener Dicken;
ein Schaltungssubstrat (3), das mit den mehreren elektronischen Bauteilen versehen ist;
eine Bodenplatine (7), die das Schaltungssubstrat befestigt;
eine Antenne (6), die im Schaltungssubstrat vorgesehen ist; und
ein Abdichtelement (5), das das Schaltungssubstrat (3) bedeckt,
wobei die elektronischen Bauteile ein erstes elektronsches Bauteil (4b) und ein zweites elektronische Bauteil (4a), das eine größere Dicke als das erste elektronische Bauteil in einer zum Schaltungssubstrat senkrechten Richtung aufweist, enthalten,
und **gekennzeichnet dadurch, dass**
das erste elektronische Bauteil (4b) in einer Umgebung der Antenne angeordnet ist und mit dem Abdichtelement (5) bis zu einer ersten Höhe bedeckt ist, und
das zweite elektronische Bauteil (4a) an einer von der Antenne (6) um einen vorgegebenen Abstand entfernten Postition angeordnet ist, um weiter von der Antenne (6) entfernt zu sein, als das erste Bauteil (4b) von der Antenne entfernt ist, und das zweite elektronische Bauteil (4b) mit dem Abdichtelement bis zu einer zweiten Höhe bedeckt ist, wobei die erste Höhe niedriger als die zweite Höhe ist.

2. Kommunikationsvorrichtung nach Anspruch 1,
wobei die erste Höhe auf der Grundlage einer Dicke der Bodenplatine (7), eines Dämpfungsverhältnisses der Vibration des Abdichtelements (5) und der Bodenplatine (7) und einer von der Antenne (6) auszusendenden Funkwellenleistungsfähigkeit bestimmt ist, und
die zweite Höhe auf der Grundlage des Abstandes zwischen der Antenne (6) und dem zweiten elektronischen Bauteil (4a) und der Funkwellenleistungsfähigkeit bestimmt ist.

3. Kommunikationsvorrichtung nach Anspruch 1,
wobei das zweite elektronische Bauteil (4a) in einer Umgebung eines mittleren Abschnitts des Schaltungssubstrats (3) angeordnet ist .

4. Kommunikationsvorrichtung nach Anspruch 1,
wobei ein Abschirmelement (9) zwischen dem Abdichtelement (5) mit der ersten Höhe und dem Abdichtelement mit der zweiten Höhe vorgesehen ist.

5. Kommunikationsvorrichtung nach Anspruch 4,
wobei das Abschirmelement (9) aus einem Material hergestellt ist, das Funkwellen überträgt.

6. Kommunikationsvorrichtung nach Anspruch 1,
wobei ein Intervall zwischen dem Abdichtelement und einer Deckenplatine (8) für die elektronischen Bauteile (4a, 4b) mit einem zweiten Abdichtelement (12) gefüllt ist, das aus einem Material gebildet ist, das Funkwellen überträgt.

7. Kommunikationsvorrichtung nach Anspruch 5,
wobei das zweite Abdichtelement (12) aus Urethanschaum hergestellt ist.

8. Knmnunikationsvorrichtung nach einem der Absprüche 1 bis 7,
wobei die Bodenplatine (7) aus einem glasfaserverstärkten Kunststoff hergestellt ist, und
das Abdichtelement (5) aus einem Polyurethanharz bergestellt ist.

9. Herstellungsverfahren für die Kommunikationsvorrichtung nach Anspruch 1, umfassend:
als ersten Schritt das Befestigen des Schaltungssubstrats (3) an der Bodenplatine (7),
als zweiten Schritt das Bilden eines konvexen Raums mit der zweiten Höhe in einem Randbereich des zweiten elektronischen Bauteils (4a);
als einen dritten Schritt das Durchführen einer Füllung mit einem Rohmaterial vor Verfestigung bis zur ersten Höhe für das erste elektronische Bauteil (4b), wobei das Rohmaterial ein Material zum Bilden des Abdichtelements (5) ist;
als einen vierten Schritt das Füllen des konvexen Raums mit dem Rohmaterial vor Verfestigung, wobei das Rohmaterial ein Material zum Bilden des Abdichtelements (5) ist; und
als einen fünften Schritt das Verfestigen des Rohmaterials nach dem Füllen im dritten und vierten Schritt.

10. Herstellungsverfahren für die Kommunikationsvorrichtung nach Anspruch 9,
wobei im zweiten Schritt ein Abschirmelement (9) mit der zweiten Höhe am Randbereich des zweiten elektronischen Bauteiles (4a) befestigt wird und dadurch der konvexe Raum gebildet wird.

11. Herstellungsverfahren für die Kommunikationsvorrichtung nach Anspruch 9,
wobei im zweiten Schritt ein Gusselement (10) auf der ersten Höhe von der Schaltplatine (3) angeordnet wird, wobei das Gusselement (10) ein Loch an einer einem Randabschnitt des zweiten elektronischen Bauteils (4a) entsprechenden Position enthält und eine einer Differenz zwischen der zweiten Höhe und der ersten Höhe entsprechende Dicke aufweist.

## Revendications

1. Dispositif de communication comportant :
de multiples composants électroniques (4a, 4b) d'épaisseur différente,
un substrat de circuit (3) pourvu des multiples composants électroniques,
une plaque inférieure (7) fixant le substrat de circuit,
une antenne (6) agencée dans le substrat de circuit, et
un élément d'étanchéité (5) recouvrant le substrat de circuit (3),
dans lequel les composants électroniques incluent un premier composant électronique (4b) et un second composant électronique (4a) qui a une épaisseur plus grande que celle du premier composant électronique dans une direction perpendiculaire au substrat de circuit,
et **caractérisé en ce que**
le premier composant électronique (4b) est agencé au voisinage de l'antenne, et est recouvert de l'élément d'étanchéité (5) jusqu'à une première hauteur, et
le second composant électronique (4a) est agencé dans une position éloignée de l'antenne (6) d'une distance prédéterminée pour être plus écarté de l'antenne (6) que le premier composant électronique (4b) ne l'est de l'antenne, et le second composant électronique (4a) est recouvert de l'élément d'étanchéité jusqu'à une seconde hauteur, la première hauteur étant inférieure à la seconde hauteur.

2. Dispositif de communication selon la revendication 1,
dans lequel la première hauteur est déterminée sur la base d'une épaisseur de la plaque inférieure (7), d'un rapport d'amortissement de vibrations de l'élément d'étanchéité (5) et de la plaque inférieure (7), et d'une qualité d'ondes radio à envoyer à partir de l'antenne (6), et
la seconde hauteur est déterminée sur la base de la distance entre l'antenne (6) et le second composant électronique (4a) et de la qualité des ondes radio.

3. Dispositif de communication selon la revendication 1,
dans lequel le second composant électronique (4a) est agencé au voisinage d'une portion centrale du substrat de circuit (3).

4. Dispositif de communication selon la revendication 1,
dans lequel un élément de protection (9) est agencé entre l'élément d'étanchéité (5) ayant la première hauteur et l'élément d'étanchéité ayant la seconde hauteur

5. Dispositif de communication selon la revendication 4,
dans lequel l'élément de protection (9) est constitué d'un matériau transmetteur d'ondes radio.

6. Dispositif de communication selon la revendication 1,
dans lequel un intervalle entre l'élément d'étanchéité et une plaque de recouvrement (8) pour les composants électroniques (4a, 4b) est rempli avec un second matériau d'étanchéité (12) formé d'un matériau transmetteur d'ondes radio.

7. Dispositif de communication selon la revendication 5,
dans lequel le second élément étanchéité (12) est constitué d'une mousse d'uréthane.

8. Dispositif de communication selon l'une quelconque des revendications 1 à 7,
dans lequel la plaque inférieure (7) est constituée d'une matière plastique renforcée par des fibres de verre, et l'élément d'étanchéité (5) est constitué d'une résine de polyuréthane.

9. Procédé de production pour le dispositif de communication selon la revendication 1, comportant :
une première étape de fixation du substrat de circuit (3) à la plaque inférieure (7),
une deuxième étape de formation d'un espace convexe ayant la seconde hauteur, sur une périphérie du second composant électronique (4a),
une troisième étape de remplissage avec une matière première avant solidification, jusqu'à la première hauteur, pour le premier composant électronique (4b), la matière première étant une matière destinée à former l'élément d'étanchéité (5),
une quatrième étape de remplissage de l'espace convexe avec la matière première avant solidification, la matière première étant une matière pour former l'élément d'étanchéité (5), et
une cinquième étape de solidification de la matière première après le remplissage de la troisième étape et de la quatrième étape.

10. Procédé de production pour le dispositif de communication selon la revendication 9,
dans lequel, à la deuxième étape, un élément de protection (9) ayant la seconde hauteur est fixé à la périphérie du second composant électronique (4a), et ainsi l'espace convexe est formé.

11. Procédé de production pour le dispositif de communication selon la revendication 9,
dans lequel, à la deuxième étape, un élément de moule (10) est agencé à la première hauteur par rapport au substrat de circuit (3), l'élément de moule (10) incluant un trou à une position correspondant à une portion périphérique du second composant électronique (4a) et ayant une épaisseur correspondant à une différence entre la seconde hauteur et la première hauteur.
